**Europäisches Patentamt**

**European Patent Office**

**Office européen des brevets**

(19)

(11) Publication number: **0 182 549**
**A1**

## (12) EUROPEAN PATENT APPLICATION

(21) Application number: **85308111.5**

(22) Date of filing: **07.11.85**

(51) Int. Cl.⁴: **H 03 L 7/18**

(30) Priority: **07.11.84 GB 8428159**

(43) Date of publication of application: **28.05.86**
**Bulletin 86/22**

(84) Designated Contracting States: **BE DE FR GB IT NL SE**

(71) Applicant: **SINCLAIR RESEARCH LIMITED, 25 Willis Road, Cambridge CB1 2AQ (GB)**

(72) Inventor: **Sinclair, Sir Clive Marles, The Stone House 3 Madingley Road, Cambridge (GB)**
Inventor: **Baker, John Mark, 24 Rooksdown Road, Winchester Hampshire (GB)**
Inventor: **Beesley, Graham Edgar, Upcott Cottage Church Lane Sparsholt, Winchester Hampshire S021 2NJ (GB)**

(74) Representative: **Carpmael, John William Maurice et al, CARPMAELS & RANSFORD 43 Bloomsbury Square, London, WC1A 2RA (GB)**

(54) **Radio frequency synthesis.**

(57) A method and apparatus for the accurate synthesis of transmit and receive frequencies in portable or mobile radio apparatus. The radio apparatus comprises a first reference oscillator (15) having a low stability, a second frequency controllable oscillator (13), a mixer (5) for mixing the signals from the first and second oscillators, an intermediate frequency filter (6) and control means (9). A signal from the first oscillator is substituted for a received signal, a signal is generated to control the second oscillator such that a signal from the mixer has a component within the bandwidth of the filter whereupon the control signal is memorised, the signal from the first oscillator is replaced with a signal received, the memorised control signal is used to identify the signal received and the control of the second oscillator is adjusted to more accurately tune into the signal received such that transmit and receive frequencies can be synthesised to within a tolerance narrower than that of the first reference oscillator.

By this means, the need for a highly stable on-board reference oscillator is eliminated and the more stable frequency of a base unit signal is used as a reference. The invention is particularly applicable to cellular radio equipment.

# RADIO FREQUENCY SYNTHESIS

This invention relates to a method for the accurate synthesis of transmit and receive frequencies in a portable or mobile radio system, without having to use a traditional phase locked frequency synthesiser and high stability reference crystal oscillator.

Conventional techniques for the synthesis of transmit and receive frequencies in radio equipment require the use of a frequency synthesiser and a reference crystal oscillator.  In high frequency stability systems, the use of a temperature compensated crystal oscillator (TCXO) is required incurring cost, size and power penalties.

We have now developed a method of frequency synthesis which does not require a temperature compensated crystal oscillator, and which is particularly, though not essentially, for use with cellular radio systems.

Due to the structure of a duplex radio system, a base station with a frequency synthesiser and TCXO will exist.  Because of the fixed nature of the base station, size and power requirements of the equipment are not overriding factors.  The present invention makes use of the base station frequency stability, and as a result, it is possible to provide a mobile/portable radio unit which uses more efficiently some of its own receiver components to derive the transmit and receive frequency stability, and as a result, the cost, size and power requirements can be considerably reduced in comparison with conventional radio receiveer/ transmitter units.

Patents Abstracts of Japan, Vol.8, No.88 (E-240) (1525), 21st April 1984, discloses a frequency synthesiser in automatic tracking adjustment equipment in which an on-board oscillator is switched into a "signal transmission system line".  A tuning voltage code is memorised when this signal is located, whereupon the equipment is switched to the receive status and the stored data is used to determine the tuning voltage. There is no mention of generating transmit frequencies and indeed the frequencies synthesised can be no more accurate than the on-board oscillator.

According to the present invention, we provide a method for the accurate synthesis of transmit and receive frequencies in portable or mobile radio apparatus which is provided with a first reference oscillator, a second frequency controllable oscillator, a mixer for mixing the signals from the first and second oscillators, intermediate frequency filter and control means, the method comprising the steps of:

substituting for a received signal, a signal from the first oscillator;

generating a signal to control the second oscillator such that the signal emerging from the mixer has a component within the bandwidth of the filter and memorising the control signal;

replacing the signal from the first oscillator with a signal received;

using the control signal memorised to identify that signal received; and

adjusting the control of the second oscillator to more accurately tune into the signal received such that transmit and receive frequencies can be synthesised to within a tolerance narrower than that of the first reference oscillator.

The memorised control signal may be adjusted according to the adjustment of the control of the second oscillator.

Preferably, a plurality of reference frequencies are generated by the reference oscillator and a plurality of corresponding control signals are memorised, each control signal being such as to produce a signal within the bandwidth of the filter.

Preferably, further control signals are generated corresponding to further frequencies, said further control signals being located by interpollation between the control signals which correspond to reference frequencies generated by the reference oscillator.

Preferably, the signal to control the second oscillator is determined by means of a frequency locked loop comprising the second frequency controllable oscillator, the mixer, the intermediate frequency filter and the control means.

Preferably, the required transmit frequency is taken from the second oscillator and is separated from the receive frequency by the centre frequency of the intermediate frequency filter.

Alternatively, or in addition, we provide a portable or mobile radio apparatus comprising a first reference oscillator, a second frequency controllable oscillator, a mixer for mixing the signals for the first and second oscillators, an intermediate frequency filter and control means wherein: the second oscillator is controlled so as to pass a signal through the filter; the signal from the reference oscillator is replaceable by a signal received at an antenna and the second oscillator is adjustable so as to more accurately tune into the signal received such that the second oscillator can synthesise transmit and receive frequencies to within a tolerance narrower than that of the first reference oscillator.

A preferred embodiment of the invention is now described by way of example with reference to the accompanying drawing, in which:-

FIGURE 1 is a schematic diagram of a duplex radio apparatus using the method of the invention; and

FIGURE 2 is a block diagram of the reference oscillator of Figure 1 and its associated elements.

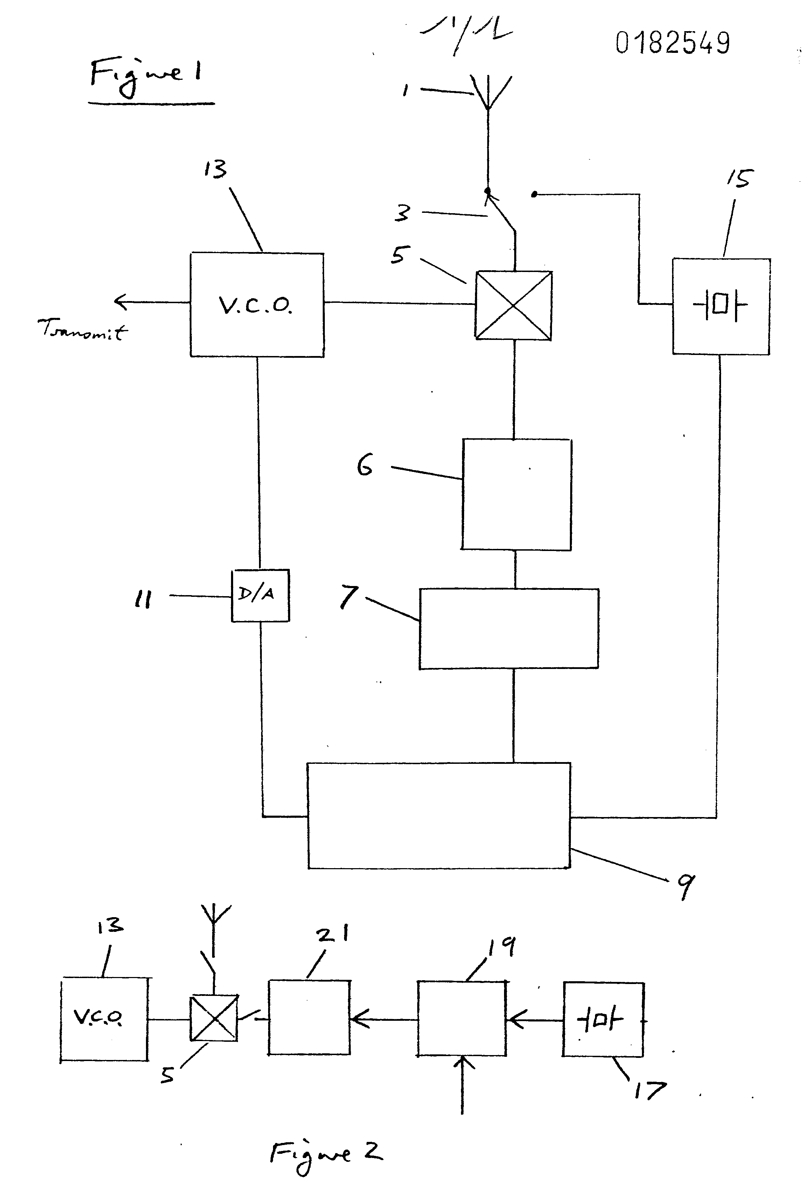

Referring to Figure 1, the apparatus comprises a receiving stage 1, switching means 3, a mixer 5, an intermediate frequency (I.F.) filter 6 and an I.F. detector 7, a control processor 9, a digital-to- analogue (D/A) convertor 11, a voltage-controlled oscillator (V.C.O.) 13 and a reference oscillator 15 having a low stability. Referring to Figure 2, the reference oscillator 15 further comprises a reference crystal oscillator 17, reference divider 19 and a multiplier 21.

The operation is best described in two stages:

A. Calibration

The reference divider 19 is set such that only one known "harmonic" of the reference oscillator 15 falls within the passband of the receiver over the given V.C.O. tuning range. This signal is fed by the switching means 3 which is controlled by the processor 9, to the mixer 5 and is simultaneously fed to the control processor 9. The control processor generates a control signal which is fed via the D/A converter 11 to the V.C.O. 13 which also supplies a signal to the mixer 5. The signal emerging from the mixer has a component which is the difference between the frequencies from the V.C.O. and the reference oscillator. For duplex radio systems, this is chosen to be 45 MHz because this makes the system totally compatible with cellular radio systems which have such a frequency split between any transmit and receive frequencies. This component is filtered out by the I.F. filter 6 which has a bandwidth at least as broad as the tolerance of the reference oscillator ($\pm$BHz) but will give a maximum signal at the centre frequency of 45MHz to within a very narrow tolerance and the signal passes to the control processor 9. Now, if no signal reaches the processor 9 from the I.F. detector 7, then the processor alters the control signal to the V.C.O. and searches up and down until the difference between the V.C.O. and reference frequencies is 45MHz and a signal is received by the processor accordingly.

At this point the controller stores the output control signal required to achieve this accurate difference of 45MHz and changes the reference divider 19 so that a new frequency is fed to the mixer 5. Thus the reference is subdivided to provide further harmonic calibration points of the V.C.O. characteristic, i.e. a further division by two will provide two extra calibration points, division by four will provide four calibration points within the tuning range of the V.C.O.. Taking this scheme to the limit, a calibration point for each channel to be synthesised could be obtained.

Channel frequency spacings such as for cellular radio are generally standardised at 25KHz apart. Having found calibration points 1MHz apart, the controller interpollates linearly to locate 40 intermediate reference markers at 25KHz apart.

The system is now calibrated.

B.    Frequency stabilising

The reference oscillator has an undesirable tolerance with temperature and ageing of $\pm$BHz. This is now switched off by switching means 3 and the receiver is scanned through the known frequency channels, with the processor knowing what control signal to apply to the V.C.O. for any given channel and it is tuned to the wanted signal from the antenna. Automatic frequency control (A.F.C.) is now used by varying the signal to the V.C.O. and searching for the peak signal from the filter 6 to update the control word in the central processing unit until the receiver is tuned onto the correct frequency and is within a given tolerance. This tolerance is narrower than that of the reference oscillator ($\pm$BHz). Continuous updating of the V.C.O. control voltage due to temperature and ageing effects is achieved by the A.F.C. control loop. The V.C.O., mixer, filter, I.F. detector, control processor and D/A converter act as a frequency locked loop. Updating can be carried out periodically, but in the preferred embodiment it is carried out at intervals of less than a microsecond, in which case it is described as continuous.

-6-

The device is unable to transmit until it is locked to this required tolerance.

An alternative embodiment is a simplex system which receives and transmits alternatively at the same frequency. During transmission, there is no fixed incoming signal for reference purposes. In this case, the V.C.O. is tuned to different transmit and receive frequencies, i.e. the transmit frequency for the V.C.O. will be 45MHz above its frequency for receiving the same channel. The control processor turns on the reference oscillator, divided into the necessary markers, and updates the control signal to the V.C.O. for temperature difference during the receive cycle. In simplex the reference oscillator markers are more closely spaced, at the channel spacings rather than for example 1MHz spacings. During the receive cycle, the calibration is made as before. Then, to transmit, the controller chooses the marker which is 45MHz from the required nominal transmit frequency. In choosing this marker, it is able to apply the compensation made during the receive cycle. This is entered to the mixer and an accurate transmit frequency is obtained.

Throughout this description and in the claims, the words "intermediate frequency" are not limited to a particular frequency range but can refer to any frequency from zero Hertz to a frequency higher even than that of the received signal.

CLAIMS:

1.        A method for the accurate synthesis of transmit and receive frequencies in portable or mobile radio apparatus which is provided with a first reference oscillator (15), a second frequency controllable oscillator (13), a mixer (5) for mixing the signals from the first and second oscillators, intermediate frequency filter (6) and control means (9), the method comprising the steps of:

substituting for a received signal, a signal from the first oscillator (15);

generating a signal to control the second oscillator (13) such that the signal emerging from the mixer has a component within the bandwidth of the filter and memorising the control signal;

replacing the signal from the first oscillator with a signal received;  and

using the control signal memorised to identify that signal received, characterised by adjusting the control of the second oscillator to more accurately tune into the signal received such that transmit and receive frequencies can be synthesised to within a tolerance narrower than that of the first reference oscillator.

2.        A method according to claim 1 wherein the memorised control signal is adjusted according to the adjustment of the control of the second oscillator.

3.        A method according to claim 1 or 2, wherein a plurality of reference frequencies are generated by the reference oscillator and a plurality of corresponding control signals is memorised, each control signal being such as to produce a signal within the bandwidth of the filter.

4.        A method according to claim 1, 2 or 3 wherein further control signals are generated corresponding to further frequencies, said further control signals being located by interpollation between the control signals which correspond to reference frequencies generated by the reference oscillator.

5.      A method according to any one of the previous claims wherein the control signal to the second oscillator is continuously updated to maintain the synthesis of the transmit and receive frequencies within the required tolerance.

6.      A method according to any one of the previous claims wherein the signal to control the second oscillator is determined by means of a frequency locked loop comprising the second frequency controllable oscillator, the mixer, the intermediate frequency filter and the control means.

7.      A method according to any one of the preceding claims wherein the required transmit frequency is taken from the second oscillator and is separated from the receive frequency by the centre frequency of the intermediate frequency filter.

8.      A method according to claim 7 wherein the centre frequency of the intermediate frequency filter is 45MHz.

9.      A portable or mobile radio apparatus comprising a first reference oscillator (15), a second frequency controllable oscillator (13), a mixer (5) for mixing the signals from the first and second oscillators, an intermediate frequency filter (6) and control means (9) wherein:  the second oscillator (13) is controllable so as to pass a signal through the filter and the signal from the reference oscillator (15) is replaceable by a signal received at an antenna (1), characterised in that the second oscillator is adjustable so as to more accurately tune into the signal received such that the second oscillator can synthesise transmit and receive frequencies to within a tolerance narrower than that of the first reference oscillator.

10.     Apparatus according to claim 9 wherein the second oscillator is adjustable so as to maximise the strength of the signal emerging from the filter.

11.     Apparatus according to claim 9 or 10 wherein a plurality of reference frequencies is generated by the reference oscillator and a plurality of control signals is memorised, each control signal being such as to produce a signal within the bandwidth of the filter.

12.    Apparatus according to claim 9, 10 or 11 wherein the control means comprises a microprocessor and the second oscillator is controlled through a digital-to-analogue converter (11).

13.    Apparatus according to any one of claims 9-12 wherein the second frequency controllable oscillator is a voltage controlled oscillator.

14.    Apparatus according to any one of claims 9-13 operating on a duplex method whereby the transmit and receive frequencies are separated by the centre frequency of the intermediate frequency filter.

15.    Apparatus according to claim 14 wherein the centre frequency of the intermediate frequency filter is 45MHz.

16.    A portable or mobile cellular radio unit including the apparatus of any one of claims 9-15.

Figure 1

0182549

Transmit

V.C.O.

D/A
11

13

3

5

6

7

9

15

Figure 2

13

V.C.O.

5

21

19

17

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| Y,D | PATENTS ABSTRACTS OF JAPAN, vol. 8, no. 88 (E-240) [1525], 21st April 1984, page 25 E 240; & JP - A - 59 6613 (MATSUSHITA DENKI SANGYO K.K.) 13-01-1984 * Abstract * | 1,3,4 | H 03 L 7/18 |
| A,D | Idem | 6,9-13 | |
| Y | EP-A-0 041 882 (THOMSON-CSF) * Page 3, lines 9-25; page 5, line 33 - page 9, line 23; page 10, line 27 - page 15, line 33 * | 1,3,4 | |
| A | | 2,5,6, 9-13 | |
| A | PHILIPS TELECOMMUNICATION REVIEW, vol. 41, no. 1, April 1983, pages 28-35, Hilversum, NL; R.J. HOWES: "MX290 - a new range of synthesized mobile radiotelephones" * Page 30, paragraph 4 - page 34, paragraph 5 * | 1,3,6-9,11-16 | **TECHNICAL FIELDS SEARCHED (Int. Cl.4)** H 03 L H 03 J |
| A | US-A-4 410 860 (KIPP et al.) | | |

The present search report has been drawn up for all claims

| Place of search | Date of completion of the search | Examiner |
|---|---|---|
| THE HAGUE | 12-02-1986 | GERLING J.C.J. |